# EUROPEAN PATENT APPLICATION

(11) **EP 2 679 890 A1**
(43) Date of publication of application: **01.01.2014**
(21) Application number: 12184728.9
(22) Date of filing: 17.09.2012
(51) Int. Cl.: F21V 7/22, F21V 29/00, F21K 99/00, F21V 3/04, F21V 21/04, F21V 23/00, F21V 23/06, H01L 33/60, F21Y 101/02, F21S 8/02

(54) **Lighting apparatus**

(30) Priority: 29.06.2012 JP 2012147019
(71) Applicant: Toshiba Lighting & Technology Corporation, Yokosuka-shi Kanagawa 237-8510 (JP)
(72) Inventor: Asami, Kenichi, Kanagawa, 237-8510 (JP); Matsunaga, Yoshiyuki, Kanagawa, 237-8510 (JP); Nakata, Shinji, Kanagawa, 237-8510 (JP); Sakai, Makoto, Kanagawa, 237-8510 (JP); Hisayasu, Takeshi, Kanagawa, 237-8510 (JP); Tamai, Hiroki, Kanagawa, 237-8510 (JP); Higuchi, Kazunari, Kanagawa, 237-8510 (JP); Kawano, Hitoshi, Kanagawa, 237-8510 (JP); Kawatsuru, Shigehisa, Kanagawa, 237-8510 (JP)
(74) Representative: Bokinge, Ole

(57) **Abstract**

A lighting apparatus (10) according to an exemplary embodiment includes a light source (20) including a light emitting element (30), a reflection portion main body (14) that is formed of an incombustible resin and is provided at an emission side of the light source, and a reflection layer (82) that is formed of resin substantially not containing halogen or phosphorus and is provided on a surface of the reflection portion main body.

## Description

### FIELD

Embodiments described herein generally relate to a lighting apparatus.

### BACKGROUND

There is a lighting apparatus which includes a light emitting element such as a light emitting diode (LED), and a wavelength conversion layer containing a phosphor.

According to such a lighting apparatus, electric power consumption can be reduced compared to an incandescent lamp, a fluorescent lamp or the like of the related art which use a filament. Furthermore, service life of the lighting apparatus can be lengthened.

In such a lighting apparatus, there is a concern that photo degradation may occur in a reflection portion or the like formed of incombustible resin.

For that reason, it is desirable to develop a lighting apparatus with improved resistance to the photo degradation.

### DESCRIPTION OF THE DRAWINGS

FIG. 1 is a schematic perspective view illustrating a lighting apparatus according to an exemplary embodiment.
FIG. 2 is a partial schematic cross-sectional view of a lighting apparatus 10 illustrated in FIG. 1.
FIG. 3 is a partial schematic cross-sectional view illustrating a lighting apparatus 110 according to a comparative example.
FIG. 4 is a schematic view illustrating an outline of a reflection portion 114 after a lighting test of the lighting apparatus 110.
FIG. 5 is a schematic view illustrating an outline of a light source 200 after the lighting test of the lighting apparatus 110.
FIG. 6 is a schematic enlarged view of a part of a peeling piece 400 illustrated in FIG. 5.
FIGS. 7A to 7D are schematic further enlarged views of a part of the peeling piece 400 illustrated in FIGS. 5 and 6.
FIGS. 8A to 8D are graphs that illustrate results of a composition analysis of an interface between an electrode pad and a wavelength conversion layer.
FIG. 9 is a graph that illustrates a reflection spectrum AR of PBT containing bromine used in the reflection portion 114 of the lighting apparatus 110.
FIG. 10 is a graph that illustrates an absorption spectrum AS of PBT containing bromine used in the reflection portion 114.
FIG. 11 is a schematic cross-sectional view illustrating a lighting apparatus according to another embodiment.
FIG. 12 is a schematic cross-sectional view illustrating a lighting apparatus according to another embodiment.
FIG. 13 is a schematic view illustrating a lighting apparatus according to another embodiment.
FIG. 14 is a schematic view illustrating a lighting apparatus according to another embodiment.
FIGS. 15A and 15B are schematic views illustrating a lighting apparatus according to another embodiment.
FIGS. 16A and 16B are schematic views illustrating a lighting apparatus according to another embodiment.

### DETAILED DESCRIPTION

According to a first aspect, there is provided a lighting apparatus which includes a light source having a light emitting element, a reflection portion main body that is formed of an incombustible resin and is provided at an emission side of the light source, and a reflection layer that is formed of resin substantially not containing halogen or phosphorus and is provided on a surface of the reflection portion main body.

Since the lighting apparatus includes the reflection layer formed of resin which substantially does not contain halogen and phosphorous, it is possible to improve resistance to photo degradation.

According to a second aspect, in the first aspect, a thickness dimension of a portion of the reflection layer near the light source is thicker than a thickness dimension of a portion far from the light source.

In the lighting apparatus, since the thickness dimension of the portion of the reflection portion near the light source is thick, it is possible to further improve resistance to photo degradation.

According to a third aspect, in the first aspect, the thickness dimension of the reflection layer is uniform.

In the lighting apparatus, since the thickness dimension of the reflection layer is uniform, it is possible to easily manufacture the lighting apparatus capable of improving resistance to photo degradation.

According to a fourth aspect, in the first aspect, the thickness dimension of the reflection layer becomes gradually thicker as the reflection layer gets closer to the light source.

In the lighting apparatus, since the thickness dimension of the reflection layer becomes gradually thicker as the reflection layer gets closer to the light source, it is possible to further improve resistance to photo degradation.

According to a fifth aspect, in the first aspect, the thickness dimension of the reflection layer becomes progressively thicker as the reflection layer gets closer to the light source.

In the lighting apparatus, since the thickness dimension of the reflection layer becomes progressively thicker as the reflection layer gets closer to the light source, it is possible to further improve resistance to photo degradation.

According to a sixth aspect, in the first aspect, the thickness dimension of the reflection layer is equal to or greater than 10 micrometers and is equal to or less than 2 millimeters.

In the lighting apparatus, since the thickness dimension of the reflection layer is equal to or greater than 10 micrometers, it is possible to suppress an occurrence of photo degradation. Furthermore, since the thickness dimension of the reflection layer is equal to or less than 2 millimeters, it is possible to maintain general incombustibility when combining the reflection layer with the reflection portion main body.

According to a seventh aspect, in the first aspect, the reflection layer is provided in at least a portion on which light emitted from the light source hits.

In the lighting apparatus, since the reflection layer is provided in at least a portion on which light emitted from the light source hits, it is possible to improve resistance to photo degradation.

According to an eighth aspect, in the first aspect, the reflection layer is white.

In the lighting apparatus, since the reflection layer is white, it is possible to improve reflectivity.

According to a ninth aspect, in the first aspect, resin substantially not containing halogen and phosphorous contains at least one of halogen and phosphorus of 1000 ppm or more and 2500 ppm or less with respect to a gross weight of resin.

In the lighting apparatus, since a content of halogen and phosphorus is within a predetermined range in resin substantially not containing halogen or phosphorus, it is possible to improve resistance to photo degradation.

According to a tenth aspect, in the first aspect, the incombustible resin has a grade in a UL 94 standard that is equal to or greater than a V-1 grade.

In the lighting apparatus, since the incombustible resin has a grade in a UL 94 standard that is equal to or greater than a V-1 grade, it is possible to provide a lighting apparatus with incombustibility.

According to an eleventh aspect, in the first aspect, light emitted from the light source has a peak of a strength in which a wavelength is equal to or less than 500 nanometers.

Since the lighting apparatus includes the reflection layer, it is possible to emit light with a peak of a strength in which the wavelength is equal to or less than 500 nanometers without lowering resistance to photo degradation.

According to a twelfth aspect, in the first aspect, the light source has an element containing silver.

Since the lighting apparatus includes the reflection layer, it is possible to use element containing silver in the light source, without lowering resistance to photo degradation.

Hereinafter, an example of exemplary embodiment will be described with reference to the drawings. In addition, in the respective drawings, the same components are denoted by the same reference numerals and the detailed descriptions thereof will be suitably omitted.

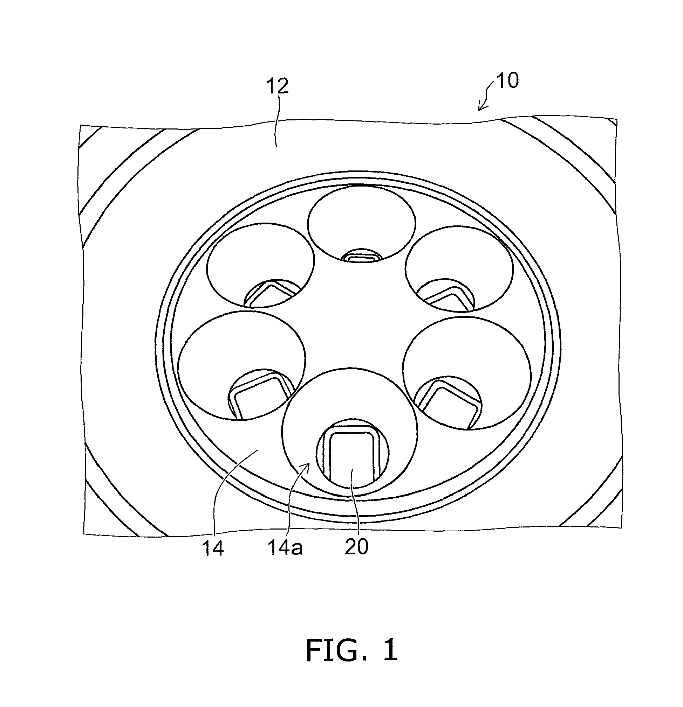

FIG. 1 is a schematic perspective view illustrating the lighting apparatus according to the exemplary embodiment.

In addition, FIG. 1 is a perspective view in which the lighting apparatus 10 is viewed from a side of a light emitting surface.

As illustrated in FIG. 1, the lighting apparatus 10 includes a main body portion 12, a reflection portion main body 14, and a light source 20 having a light emitting element 30. The reflection portion main body 14 is accommodated in the frame-shaped main body portion 12. The reflection portion main body 14 is provided with a plurality of concave portions 14a. Light sources 20 are provided inside the respective concave portions 14a.

In addition, the lighting device 10 illustrated in FIG. 1 is merely an example, and for example, the shapes, the numbers or the like of the concave portions 14a and the light sources 20 can be suitably changed. For example, each one of the concave portion 14a and the light source 20 may be provided.

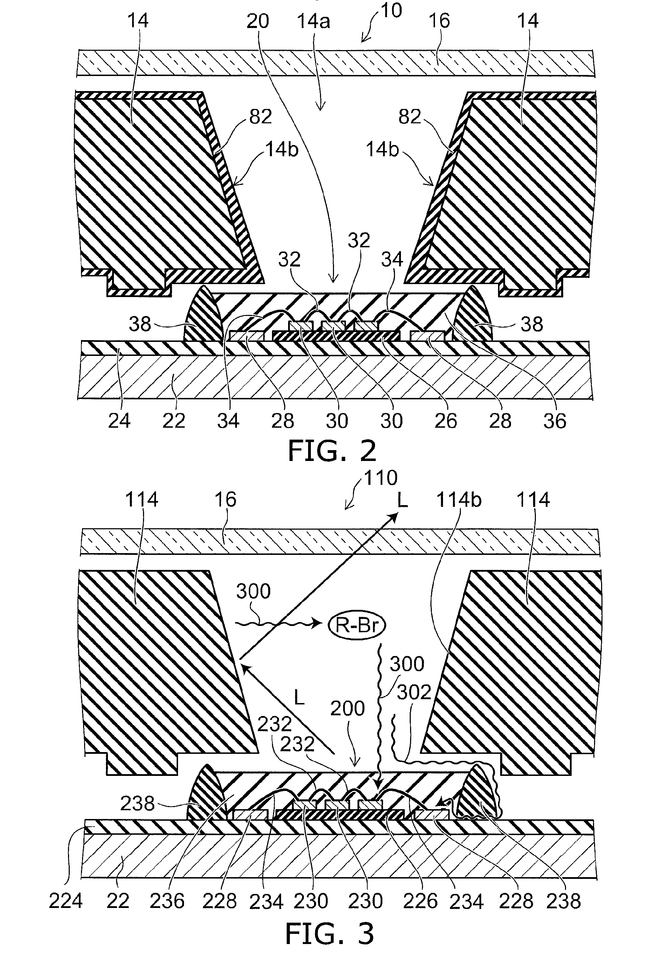

FIG. 2 is a partial schematic cross-sectional view of the lighting apparatus 10 illustrated in FIG. 1.

In addition, FIG. 2 is a longitudinally cross-sectional view near one concave portion 14a of the reflection portion main body 14 of the lighting apparatus 10.

A transparent cover 16 is provided above the reflection portion main body 14. In addition, FIG. 1 illustrates a state where the transparent cover 16 is removed.

The reflection portion main body 14 is provided at an emission side of the light source 20.

The reflection portion main body 14 is formed of the incombustible resin.

In the lighting apparatus 10, since the temperature of the light source 20 rises, the reflection portion main body 14 and the transparent cover 16 are formed of resin predetermined incombustibility.

In this case, for example, it is desirable to use resin having a grade in the UL 94 standard of a V-1 grade or more, that is, corresponding to some grades of V-1, V-0, 5VB, and 5VA.

As an example of the above incombustible resin, there is resin containing any one of halogen such as bromine (Br) and phosphorus. For example, it is possible to adopt PBT (polybutylene terephthalate) containing bromine, or the like.

A reflection layer 82 adheres closely to and is provided on the surface of the reflection portion main body 14.

The reflection layer 82 is provided so as to prevent the reflection portion main body 14 from being optically degraded.

That is, the reflection layer 82 is provided so as to prevent the contained element and a compound thereof (for example, bromine, a compound or the like including bromine) from being separated from resin forming the reflection portion main body 14.

In addition, the details of the photo degradation of the reflection portion main body 14 will be described later.

Furthermore, the reflection layer 82 also has a function of reflecting the light emitted from the light source 20 and preventing the light emitted from the light source 20 from reaching the surface of the reflection portion main body 14.

That is, the reflection layer 82 has reflectivity and light blocking properties to light emitted from the light source 20.

The reflection layer 82 can be formed using resin in which the contained element and the compound thereof are not detached when light is emitted from the light source 20.

For example, the reflection layer 82 can be formed using resin which substantially does not contain halogen or phosphorous.

Furthermore, the reflection layer 82 is preferably formed using white resin in consideration of reflecting the light emitted from the light source 20 and preventing the light emitted from the light source 20 from reaching the surface of the reflection portion main body 14.

As resin used for forming the reflection layer 82, it is possible to adopt, for example, an LCP (Liquid Crystal Polymer), PEI (polyetherimide), PEEK (polyetheretherketone), PPE (Polyphenyleneether), PPO (Polyphenyleneoxide), PBT (Poly Buthylene Terephthalete), PET (Poly Ethylene Terephthalate), PA (Polyamide), PAR (Polyarylate), PC (Polycarbonate) or the like.

Moreover, when using any one of those resins, it should use a resin which substantially does not contain halogen and phosphorous.

In doing so, it is possible to improve resistance to photo degradation of the lighting apparatus 10.

Furthermore, a complex resin containing 50 weight % or more of a resin mentioned above may be used. When using the complex resin, it is easy to design heat resistance and incombustibility.

In addition, in the specification, the expression "substantially not containing" implies that the content is zero or even if the content is not zero, that the content is within a range which does not affect the product life required for the lighting apparatus 10. For example, when the service life required for the lighting apparatus 10 is forty thousand hours, if the service life is within an achieved range (for example, about 1000 ppm or more and 2500 ppm or less to resin gross weight), halogen or phosphorus may be contained.

Herein, in resin substantially not containing halogen or phosphorus, incombustibility tends to be lowered. For that reason, if the thickness dimension of the reflection layer 82 is thickened too much, the entire incombustibility including the reflection portion main body 14 may depart from the grade in the UL 94 standard.

Meanwhile, if the thickness dimension of the reflection layer 82 is thinned too much, the detachment of halogen and phosphorus may not be suppressed, or it may be impossible to prevent light emitted from the light source 20 from reaching the surface of the reflection portion main body 14.

For that reason, it is desirable that the thickness dimension of the reflection layer 82 be equal to or greater than 10 micrometers and be equal to or less than 2 millimeters.

In this case, the reflection layer 82 can be provided so that the thickness dimension is uniform.

However, as illustrated in FIG. 2, if the thickness dimension of a region near the light source 20 is thick, it is possible to improve an effect of suppressing the detachment of halogen and phosphorus or preventing the light emitted from the light source 20 from reaching the surface of the reflection portion main body 14.

In this case, as illustrated in FIG. 2, the thickness dimension of the reflection layer 82 becomes gradually thick as the reflection layer 82 becomes closer to the light source 20, and the thickness dimension of the reflection layer 82 becomes progressively thick as the reflection layer 82 becomes closer to the light source 20.

That is, the thickness dimension of a portion of the reflection portion 82 near the light source 20 can become thicker than the thickness dimension of a portion far from the light source 20.

Furthermore, as illustrated in FIG. 2, the reflection layer 82 can be provided so as to cover the entire surface of the reflection portion main body 14.

In this case, the reflection layer 82 can be provided only at least in a portion on which light emitted from the light source 20 hits, of the surface of the reflection portion main body 14.

However, if the reflection layer 82 is provided so as to cover the entire surface of the reflection portion main body 14, it is possible to enhance an effect of suppressing the detachment of halogen and phosphorous.

Although a forming method of the reflection layer 82 is not particularly limited, for example, it is possible to form the reflection layer 82 on the surface of the reflection portion main body 14 using a spray coating method or the like.

Furthermore, the reflection layer 82 may be formed in a film shape in advance, and the reflection layer 82 may be bonded to the surface of the reflection portion main body 14.

Next, returning FIG. 2, other elements provided in the lighting apparatus 10 will be described as an example.

The light source 20 is provided below the concave portion 14a of the reflection portion main body 14. The light source 20 has a metallic support substrate 22 and an insulating layer 24 that covers the surface thereof. An implementation pad 26 and an electrode pad 28 are each formed over the insulating layer 24. A plurality of light emitting elements 30 are mounted on the implantation pad 26. Such light emitting elements 30 are, for example, connected in series using a metal wire 32. Furthermore, the light emitting elements 30 are connected to both electrode pads 28 using the metal wire 34. For that reason, it is possible to make the light emitting elements 30 shine by causing the electric current to flow between the pair of electrode pads 28.

As the light emitting element 30, for example, a light emitting diode can be adopted as an example. When, for example, using a gallium nitride (GaN)-based compound semiconductor as a material of an active layer of the light emitting diode, it is possible to obtain a short-wavelength light having a wavelength of 500 nanometers or less.

That is, light emitted from the light source 20 has a peak of strength of the wavelength of 500 nanometers or less.

However, the material of the active layer is not limited to the gallium nitride-base compound semiconductor.

Furthermore, as the light emitting element 30, in addition to the light emitting diode, for example, it is possible to use an organic light emitting diode (OLED), an inorganic electroluminescence light emitting element, an organic electroluminescence light emitting element, other electroluminescence type light emitting elements or the like.

Silver (Ag) or an alloy containing silver is provided on the surface of the implementation pad 26 and the electrode pad 28. Silver has high reflectivity to a short-wavelength of blue light or the like. Accordingly, by providing silver or silver alloy on the surface of the implementation pad 26 and the electrode pad 28, it is possible to reflect light radiated from the light emitting element 30 at high reflectivity to take the light to the outside.

That is, the light source 20 has an element containing silver.

The light emitting element 30 and the metal wires 32 and 34 are covered by a wavelength conversion layer 36. The wavelength conversion layer 36 has, for example, a structure in which phosphor is dispersed in resin. The wavelength conversion layer 36 is surrounded by a frame 38 formed therearound. As resin constituting the wavelength conversion layer 36, for example, a silicone-based resin can be adopted as an example. Furthermore, as a material of the frame 38, for example, a silicone-based resin can be used. If the silicone-based resin is used, even when light of a short-wavelength such as blue light and ultraviolet light is emitted from the light emitting element 30, the photo degradation can be suppressed.

Phosphor included in the wavelength conversion layer 36 absorbs light emitted from the light emitting element 30 and radiates light of other wavelengths. For example, when blue light of a wavelength of 450 nanometers to 500 nanometers is emitted from the light emitting element 30, it is possible to convert blue light into yellow light by the phosphor.

Thus, white light can be obtained by converting a part of blue light emitted from the light emitting element 30 into yellow light and mixing the yellow light with the blue light emitted to the outside without being converted.

In this manner, light such as white light emitted from the light source 20 can be taken to the outside from the concave portion 14a of the reflection portion main body 14 via the transparent cover 16. Light emitted diagonally from the light source 20 is reflected by the reflection layer 82 provided on a surface of a sloped surface 14b of the reflection portion main body 14 and can be taken to the outside via the transparent cover 16. However, light taken from the lighting apparatus 10 according to the exemplary embodiment is not limited to white light.

Furthermore, when using resin as a material of another element to which light from the light source 20 is directly or indirectly irradiated, it is possible to use resin which substantially does not contain halogen and phosphorous. For example, in the case of the lighting apparatus 10 illustrated in FIGS. 1 and 2, it is possible to use resin which substantially does not contain halogen or phosphorus as the material of the transparent cover 16.

If the transparent cover 16 is formed using resin which substantially does not contain halogen or phosphorus, although incombustibility of the transparent cover 16 may be lowered, since the light source 20 serving as a heat source is far from the transparent cover 16, the influence of incombustibility drop is small.

If resin substantially not containing halogen or phosphorus as the material of another element to which light from the light source 20 is directly and indirectly irradiated, it is possible to further improve resistance to photo degradation of the lighting apparatus 10.

Next, the photo degradation of the reflection portion 114 or the like will be further described.

FIG. 3 is a partial schematic cross-sectional view illustrating a lighting apparatus 110 according to a comparative example.

As illustrated in FIG. 3, the lighting apparatus 110 includes a reflection portion 114, a light source 200 or the like.

The reflection portion 114 having a sloped surface 114b corresponds to the reflection portion main body 14 of the lighting apparatus 10 mentioned above.

However, the reflection portion 114 is formed of PBT containing bromine of 25000 ppm.

Furthermore, the reflection portion 82 is not provided on the surface of the reflection portion 114.

The light source 200 is provided with a support substrate 22, an insulating layer 224, an implementation pad 226, an electrode pad 228, a light emitting element 230, a wavelength conversion layer 236 and a frame 238.

The light source 200 corresponds to the light source 20 of the lighting apparatus 10 mentioned above.

The light source 200 is formed on the white insulating layer 224 (corresponding to the insulating layer 24), and the light emitting element 230 (corresponding to the light emitting element 30) sealed in the wavelength conversion layer 236 (corresponding to the wavelength conversion layer 36) is provided in the frame 238 (corresponding to the frame 38). The light emitting element 230 is mounted on the implementation pad 226 (corresponding to the implementation pad 26). Furthermore, the electrode pads 228 (corresponding to the electrode pad 28) are provided at both sides of the implementation pad 226 and are connected to the light emitting element 230 by a metal wire 232 and a metal wire 234. The surfaces of the implementation pad 226 and the electrode pad 228 are covered by silver.

Next, a mechanism of degradation of the reflection portion 114, the electrode pad 228 or the like in the lighting apparatus 110 according to the comparative example will be described.

If light L including components of a short wavelength is emitted from the light source 200, a part thereof is reflected by the sloped surface 114b of the reflection portion 114 and is taken to the outside.

If the reflection portion 114 containing halogen and phosphorus is irradiated with light of the short wavelength, the decomposition and denaturation occur, and halogen and phosphorus or the compound thereof are detached from the reflection portion 114.

Furthermore, decomposition and denaturation in the reflection portion 114 may also be promoted when the temperature rises. In addition, when the temperature rises, absorptivity of light in resin constituting the reflection portion 114 rises, and decomposition and denaturation due to the absorption of light may be accelerated.

In FIG. 3, as an example, a situation will be described where organic matter R-Br containing bromine is detached from the reflection portion 114.

As indicated by an arrow 300, the detached organic matter R-Br reaches the implementation pad 226 and the electrode pad 228 via the wavelength conversion layer 236, reacts with silver of the surface thereof, and causes darkening, cohesion, detachment and disconnection.

Furthermore, as an entry course of the detached R-Br, for example, as indicated by an arrow 302, it is also possible to consider a course going though an interface in the frame 238 or the lower side of the frame 238.

Furthermore, it is also possible to consider that, before or after the organic matter R-Br reaches the implementation pad 226 and the electrode pad 228, the organic matter is decomposed by light of the short wavelength emitted from the light emitting element 230, and the more active bromine ion is formed.

In addition, although a situation of containing bromine is described as an example in FIG. 3, the exemplary embodiments are not limited thereto. The reason is because, like bromine, halogen or phosphorus other than bromine also react with silver, and causes darkening, cohesion, detachment and disconnection.

According to the mechanism mentioned above, the irradiation of light of the short wavelength or the rise of the temperature causes the decomposition and the denaturation of resin, and as a consequence, halogen and phosphorus or the compound thereof is detached. Moreover, the detached halogen and phosphorus or the compound thereof react with silver of the electrode pad 228 and the implementation pad 226, which causes the drop of illumination, the disconnection of the metal wire or the like.

Next, a state of the degradation of the reflection portion 114, the electrode pad 228 or the like in the lighting apparatus 110 according to a comparative example will be further described.

The lighting apparatus 110 illustrated in FIG. 3 was subjected to a lighting test, and the degradation of the reflection portion 114, the electrode pad 228 or the like was reviewed.

In the lighting test, after lighting the lighting apparatus 110 at an output of 57 watts, illumination gradually dropped along with the elapse of time, and the non-lighting state was obtained at substantially 4000 hours.

Moreover, the state of the degradation of the reflection portion 114, the electrode pad 228 or the like of the lighting apparatus 110 of the non-lighting state was observed.

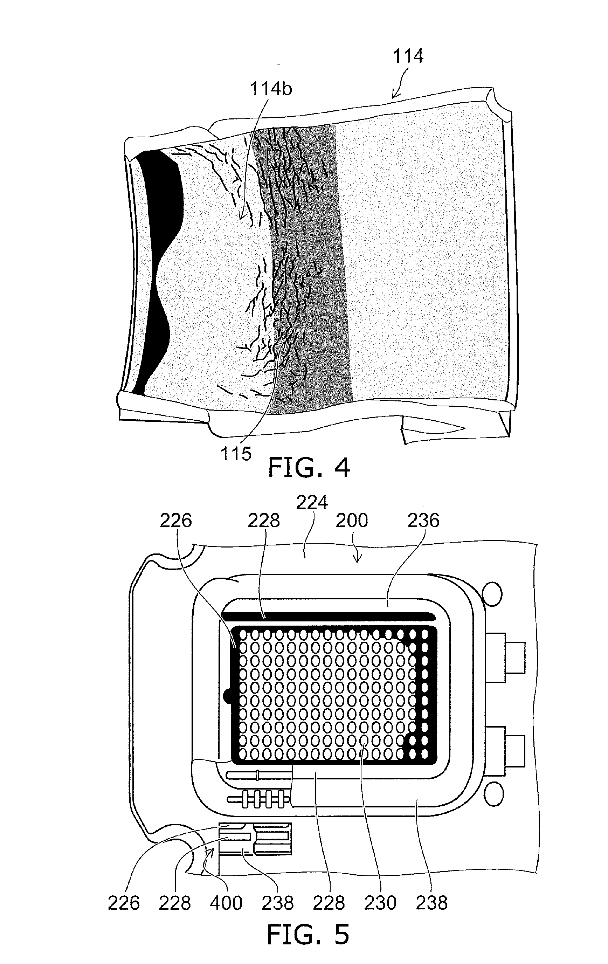

FIG. 4 is a schematic view illustrating an outline of the reflection portion 114 after the lighting test of the lighting apparatus 110 according to a comparative example.

That is, FIG. 4 illustrates a surface state of the sloped surface 114b of the reflection portion 114. In addition, the sloped surface 114b corresponds to the sloped surface 14b in FIG. 2.

Although the sloped surface 114b was white before the lighting test, the sloped surface 114b after the lighting test turns black and a crack 115 is partially generated. That is, it is understood that the surface of the PBT containing bromine makes denaturation. It is conceivable that reflectivity of the sloped surface 114b drops due to the darkening and the crack 115, and the illumination of the lighting apparatus 110 is lowered.

FIG. 5 is a schematic view illustrating an outline of the light source 200 after the lighting test of the lighting apparatus 110 according to a comparative example.

As illustrated in FIG. 5, a left end portion and a right portion facing the implementation pad 226 are each darkened. Furthermore, the electrode pad 228 provided above and below the implementation pad 226 is also darkened. In the lighting apparatus 110 according to the comparative example, it is understood that reflectivity of light drops and illumination drops due to the darkening.

Furthermore, after checking a portion of the electrode pad 228 in detail, it was understood that a darkened surface layer of the electrode pad 228 is peeled and a bonding portion of the metal wire 234 is also peeled. That is, it was proved that the metal wire 234 enters the disconnection state, and non-lighting state is obtained.

FIG. 5 illustrates that a peeled piece 400 is placed inside out in a left lower part of the light source 200.

The peeling piece 400 has a surface layer of the implementation pad 226, a surface layer of the electrode pad 228, a wavelength conversion layer 236 sealing therearound, and a part of a frame 238.

That is, in darkened portions of the implementation pad 226 and the electrode pad 228, since the surfaces thereof perform denaturation, the darkened portions are simply peeled.

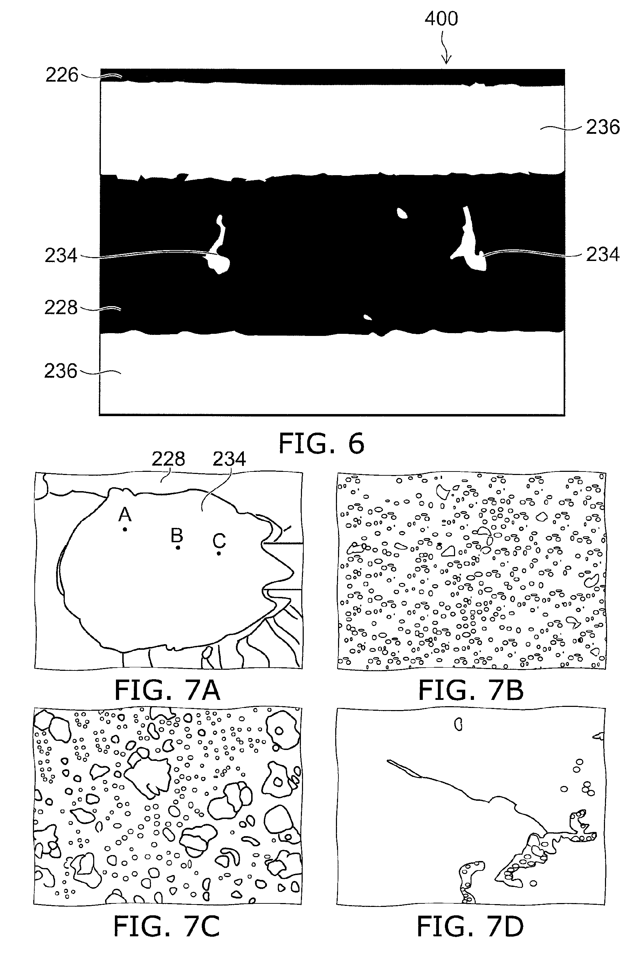

FIG. 6 is a schematic enlarged view of a part of the peeling piece 400 illustrated in FIG. 5.

The surface layer of the peeled electrode pad 228 becomes black and exhibits an outline condensed in a particle shape. Furthermore, the metal wire 234 is also peeled from the remaining portion of the electrode pad 228 (a portion remaining over the insulating layer 224). That is, it is understood that sliver of the electrode pad 228 performs denaturation.

FIGS. 7A to 7D are a further enlarged schematic view of a part of the peeling piece 400 illustrated in FIGS. 5 and 6.

That is, FIG. 7A illustrates a leading end of a bonding portion of the metal wire 234 peeled together with the electrode pad 228. Furthermore, FIG. 7B is a schematic enlarged view of an A portion in FIG. 7A, FIG. 7C is a schematic enlarged view of a B portion in FIG. 7A, and FIG. 7D is a schematic enlarged view of a C portion in FIG. 7A.

Although a material of the metal wire 234 is gold (Au), the surface thereof becomes alloy by being bonded to a silver layer of the electrode pad 228. Moreover, a structure of a condensed particle shape is also seen on the surface of the peeled metal wire 234. As a result of EPMA (Electron Probe Micro Analysis) analysis, it was understood that the structure of the particle shape contains silver.

That is, it is understood that denaturation of silver occurs on a bonding interface between the metal wire 234 and the electrode pad 228.

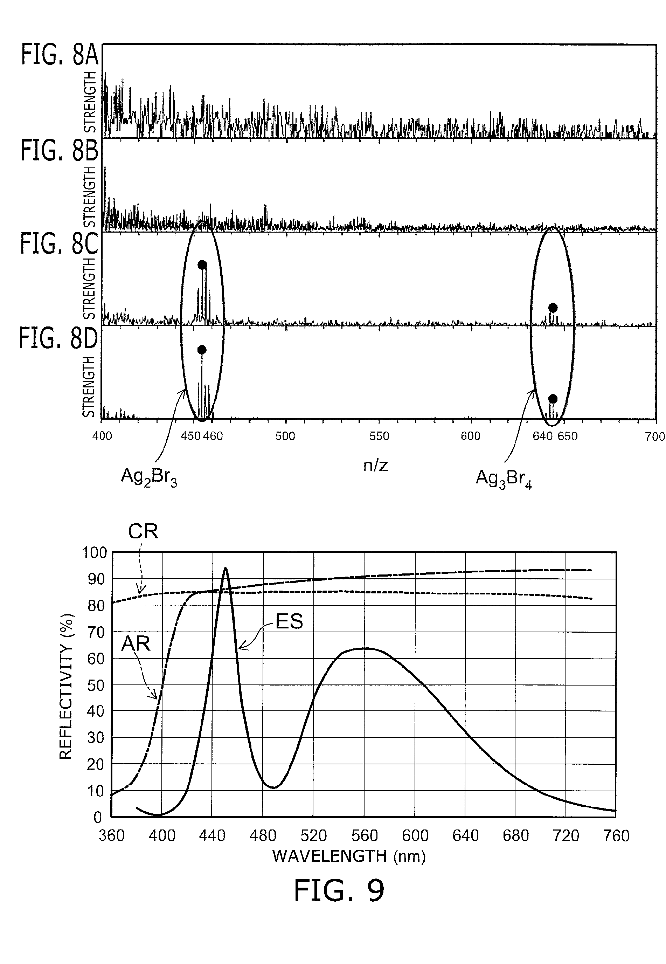

FIGS. 8A to 8D are a graph that illustrates a result of a composition analysis of an interface between of the electrode pad and the wavelength conversion layer.

Herein, as in the peeling piece 400 illustrated in FIGS. 5 to 7, the wavelength conversion layer on the electrode pad was peeled, and the surface of the peeling pad and the surface of the electrode pad remaining at the insulating layer 24 side each were subjected to a composition analysis using SIMS (Secondary Ion Mass Spectroscopy) in a position of the electrode pad.

FIG. 8A illustrates a result of the composition analysis of the surface of the electrode pad 28 side of the wavelength conversion side 36 that is peeled from the light source 20 of the lighting apparatus 10 according to the exemplary embodiment.

FIG. 8B illustrates a result of the composition analysis of the surface of the electrode pad 28 remaining at the insulating layer 24 side by peeling the wavelength conversion layer 36 from the light source 20 of the lighting apparatus 10 according to the exemplary embodiment.

FIG. 8C illustrates a result of the composition analysis of the surface of the electrode pad 28 side of the peeling piece 400 peeled from the light source 200 of the lighting apparatus 110 according to the comparative example.

FIG. 8D illustrates a result of the composition analysis of the surface of the electrode pad 228 remaining at the insulating layer 224 side by peeling the peeling piece 400 from the light source 200 of the lighting apparatus 110 according to the comparative example.

As will be understood from FIGS. 8C and 8D, in the lighting apparatus 110 according to the comparative example, even in the peeling piece 400 side (FIG. 8C) and even in the insulating layer 224 side (FIG. 8D), in the range of a transverse axis n/z of 450 to 460, a peak of Ag₂Br₃ is seen, and in the range of the transverse axis n/z of 640 to 650, a peak of Ag₃Br₄ is seen. Furthermore, as a consequence of analysis, a peak of AgBr and a peak of AgBr₂ were also confirmed.

On the contrary, as will be understood from FIGS. 8A and 8B, in the lighting apparatus 10 according to the exemplary embodiment, even at the side (FIG. 8A) of the peeling piece, and even on the insulating layer 24 side (FIG. 8B), a meaningful peak is not seen.

From the analysis result, it is understood that, in the lighting apparatus 110 according to the comparative example, bromine or the compound containing bromine is detached from the reflection portion 114 during lighting test, bromine or the compound containing bromine reaches the surface of the electrode pad 228 and reacts with silver, and silver bromide is formed. Moreover, in the process when silver bromide is formed in this manner, as illustrated in FIGS. 5, 6 or the like, it is considered that the surfaces of the electrode pad 228 and the implementation pad 226 become dark and condense in a particle shape and are peeled, and the disconnection of the metal wire 234 is generated.

Furthermore, it is considered that bromine or the compound containing bromine is detached from the reflection portion 114, thus as illustrated in FIG. 4, the sloped surface 114b of the reflection portion 114 becomes dark, and the crack 115 is generated.

FIG. 9 is a graph that illustrates a reflection spectrum AR of PBT which contains bromine used in the reflection portion 114 of the lighting apparatus 110 according to the comparative example.

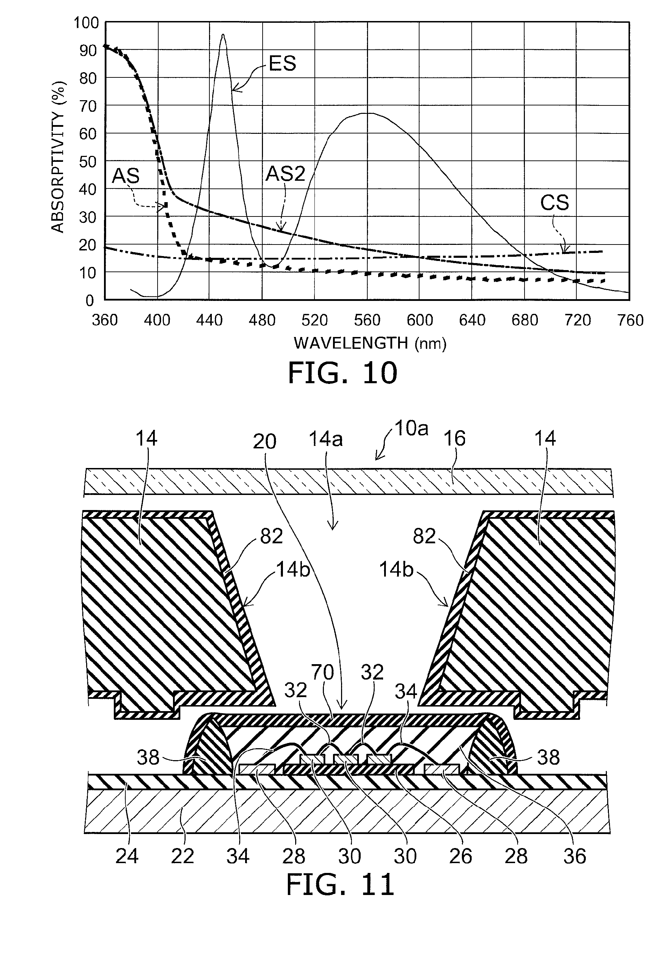

Furthermore, FIG. 10 is a graph that illustrates an absorption spectrum AS of PBT which contains bromine used in the reflection portion 114 of the lighting apparatus 110 according to the comparative example.

In addition, FIGS. 9 and 10 also illustrate a reflection spectrum CR and an absorption spectrum CS of a sample in which aluminum is deposited on the surface of the reflection portion 114 as a reference example.

Furthermore, FIGS. 9 and 10 also illustrate a light emitting spectrum ES of light that is emitted from the light source 200.

Furthermore, FIG. 10 also illustrates an absorption spectrum AS2 of PBT containing bromine which is maintained in a thermostatic chamber for 120 hours at 150°C and is changed into yellow by thermal degradation.

When viewing the light emitting spectrum ES of light that is emitted from the light source 200, blue light having a peak of a wavelength of about 450 nanometers and yellow light having a wide spectrum in which a peak of a wavelength of about 560 nanometers.

Meanwhile, the absorption spectrum AS of PBT containing bromine illustrates a transition in which absorptivity suddenly rises at the short wavelength side as a boundary of a wavelength of about 420 nanometers in an initial state.

However, in the absorption spectrum AS2 after being maintained for 120 hours at 150°C, absorptivity rises further than the absorption spectrum AS over a wide range of a wavelength from 400 nanometers to 700 nanometers.

In addition, when viewing the absorption spectrum CS of the reflection portion 114 in which aluminum is deposited as a reference example, at the wavelength side that is longer than the wavelength of 440 nanometers, absorptivity is higher than PBT containing bromine of the initial state.

However, it is understood that there is no sudden increase of absorptivity even in the wavelength that is equal to or less than the wavelength of 440 nanometers, and low absorptivity can be maintained from the long wavelength side to the short wavelength side.

It is understood from FIGS. 9 and 10 that, in the PBT, a start (about 420 nanometers) portion of absorptivity overlaps a skirt of the peak of blue light of the light source 200 even in the initial state.

That is, it is understood that the PBT absorbs the short wavelength components of light emitted from the light source 200 even in the initial state and may cause decomposition and denaturation.

Moreover, when the decomposition and denaturation of the PBT containing bromine occur, as illustrated in FIG. 4, the surface become dark, the crack 115 is generated, and reflectivity of light decreases. The decrease causes a drop of illumination.

A problem is not generated that the decomposition and denaturation of the PBT containing bromine when light emitted from the light source is mainly visible ray, and a light quantity and a temperature are low. However, if light emitted from the light source is a large light quantity which contains a lot of short wavelength components, in the element near the light source, the surface may become dark or the crack 115 may be generated.

Furthermore, when the decomposition and denaturation of the PBT containing bromine occur, bromine or the compound containing bromine is detached and reacts with silver of the electrode pad 228 and the implementation pad 226, and darkening, cohesion, peeling or the like occur.

Particularly, in the lighting apparatus 110 in which the light source 200 and the reflection portion 114 are placed in a space sealed by the transparent space 16 or the like, gas including the detached bromine or the compound containing bromine is easily filled, and problems such as darkening, cohesion and peeling easily occur.

For that reason, in the lighting apparatus 10 according to the exemplary embodiment, the reflection layer 82 is provided on the surface of the reflection portion main body 14.

Herein, as illustrated in FIG. 10, if aluminum is deposited on the surface of the reflection portion 114, absorptivity does not suddenly rise even in the wavelength of 440 nanometers or less, and low absorptivity can be maintained from the long wavelength side to the short wavelength side.

That is, if the surface of the reflection portion 114 is covered by a material having light blocking properties, low absorptivity can be maintained from the long wavelength side to the short wavelength side.

Furthermore, if a material having the absorption spectrum CS lower than aluminum is selected at the long wavelength side further than the wavelength of 440 nanometers, it is possible to further lower absorptivity from the long wavelength side to the short wavelength side.

Herein, as illustrated in FIG. 10, at the long wavelength side further than the wavelength of 440 nanometers, the PBT has absorptivity that is lower than aluminum.

However, if the reflection layer 82 is formed using the PBT containing bromine or the like, bromine, the compound containing bromine or the like is detached from the reflection layer 82.

For that reason, in the lighting apparatus 10 according to the exemplary embodiment, the reflection layer 82 is formed using resin which does not substantially contain halogen and phosphorous.

For that reason, it is possible to obtain absorptivity that is lower than a situation of depositing aluminum, and low absorptivity can be maintained from the long wavelength side to the short wavelength side.

FIG. 11 is a schematic cross-sectional view illustrating a lighting apparatus according to another embodiment.

A lighting apparatus 10a illustrated in FIG. 11 is provided with a diffusion restriction portion 70 that covers the light source 20.

The diffusion restriction portion 70 preferably has a material and a structure which have high transmissivity to light emitted from the light source 20 and are able to maintain a certain degree of airtightness. As a material of the diffusion restriction portion 70, an organic material, an inorganic material or the like can be used. The diffusion restriction portion 70 can be formed by applying, curing and drying a liquid organic material or inorganic material so as to cover the light source 20. In this case, as a raw material of the diffusion restriction portion 70, a water glass or the like can be used.

In addition, it is not required to necessarily form the diffusion restriction portion 70 so as to come into contact with the light source 20. That is, the diffusion restriction portion 70 may cover the periphery of the light source 20, and may prevent halogen, phosphorus or the compound containing these components from entering inside the light source 20. For that reason, for example, the diffusion restriction portion 70 may be provided around the light source 20 while being separated from the light source 20.

When the diffusion restriction portion 70 is provided, if halogen, phosphorous or the compound containing these components penetrates the reflection layer 82, it is possible to prevent halogen, phosphorous or the compound containing these components from entering inside the light source 20.

For that reason if halogen, phosphorous or the compound containing these components is generated inside the light apparatus 10a, it is possible to suppress darkening or cohesion of the implementation pad 26 of the light source 20, the electrode pad 28 or the like, the disconnection of the metal wire or the like.

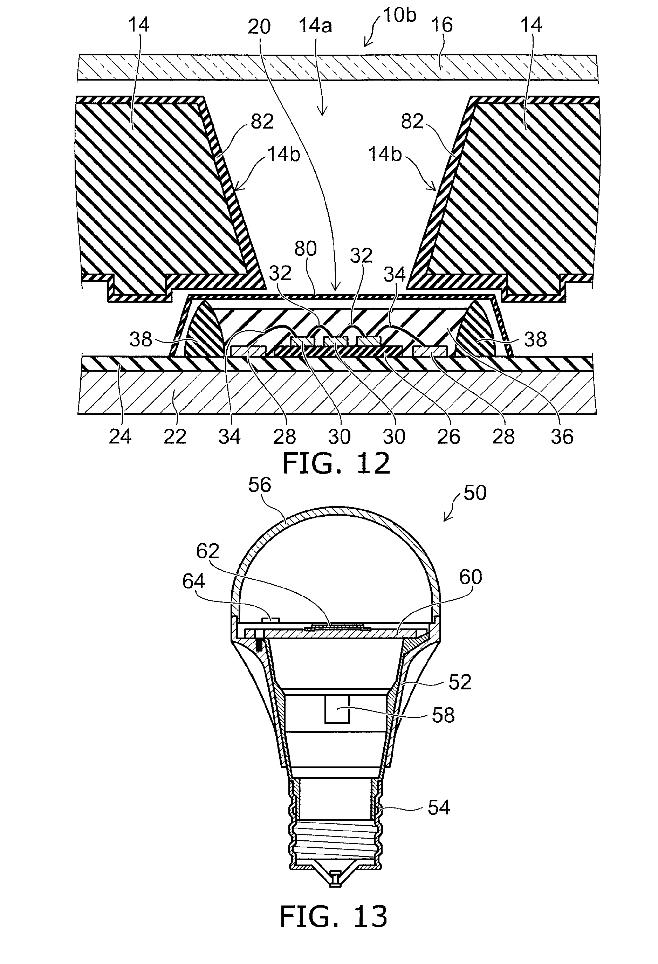

FIG. 12 is also a schematic cross-sectional view illustrating a lighting apparatus according to another embodiment.

A lighting apparatus 10b illustrated in FIG. 12 is provided with a filter 80.

The filter 80 is provided between the light source 20 and the reflection portion main body 14.

The filter 80 has optical characteristics of selectively absorbing light of short wavelength side of lights that is emitted from the light source 20.

For example, if the reflection layer 82 is formed using the PBT that does not substantially contain halogen or phosphorus, as illustrated in FIG. 10, absorptivity rises in the wavelength of 420 nanometers or less. For that reason, if the filter 80 is provided which absorbs light of the short wavelength side further than about the wavelength of 420 nanometers, it is possible to reduce light of short wavelength side which is absorbed by the reflection layer 82.

In addition, as in the diffusion restriction portion 70 illustrated in FIG. 11, the filter 80 may be provided so as to come into contact with the light source 20.

FIGS. 13 to 15 are schematic views illustrating a lighting apparatus according to another embodiment.

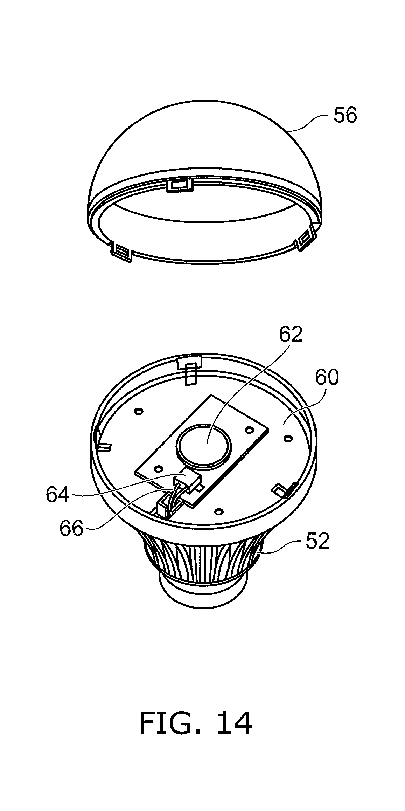

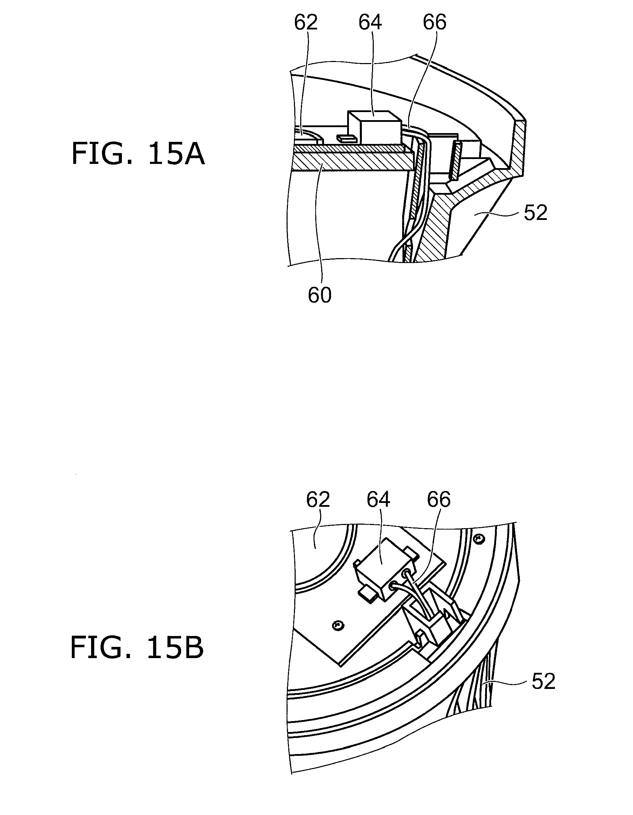

In addition, FIG. 13 is a cross-sectional view of the lighting apparatus, and FIG. 14 is a perspective exploded view of the lighting apparatus, and FIGS. 15A and 15B are partially exploded perspective views of the lighting apparatus.

A lighting apparatus 50 according to the exemplary embodiment is a so called "electric bulb type" and can be mounted on an appliance used for an incandescent electric lamp of the related art as it is.

As illustrated in FIGS. 13 to 15, a metal cap portion 54 is provided in one end portion of the main body portion 52. The metal cap portion 54 can be screwed into a socket on which an incandescent light bulb is mounted.

A transparent or semitransparent cover 56 is provided in the other end portion of the main body portion 52.

A power source substrate 58 is accommodated inside the main body portion 52.

Furthermore, an installation substrate 60 is fixed to the other end portion of the main body portion 52, and a light source 62 is provided thereon. The light source 62 corresponds to the light source 20 illustrated in FIGS. 1 and 2, and is provided with an implementation pad, an electrode pad, a light emitting element, a wavelength conversion layer, a metal wire or the like (all the components are not illustrated).

A connection member 64 is provided on the installation substrate 60. The connection member 64 is, for example, a connector, and connects a wiring 66 connected to the power source substrate 58 with the light source 62. The wiring 66 has a structure in which a core line of a conductor is covered by an insulator.

In the exemplary embodiment, for example, the coating or the like of the connection member 64 and the wiring 66 is formed of resin which does not substantially contain halogen or phosphorus. In the manner, it is possible to prevent that resin constituting the coating or the like of the connection member 64 and the wiring 66 is decomposed and performs denaturation, and halogen, phosphorus or the compound is detached. For that reason, it is possible to suppress that halogen, phosphorus or the compound thereof reacts with silver of the implementation pad and the electrode pad provided in the light source 62, and darkening, cohesion, the disconnection of the metal wire or the like occurs.

As a consequence, it is possible to provide a lighting apparatus having higher reliability.

In addition, in the case of the lighting apparatus 50 illustrated in FIGS. 13 to 15, the wiring 66 is placed behind the connection member 64 when viewed from the light source 62. However, a part of light emitted from the light source 62 is reflected by elements such as the installation substrate 60 and the cover 56 and is also irradiated to the wiring 66. For that reason, it is preferable that the coating or the like of the connection member 64 and the wiring 66 be formed of resin which does not substantially contain halogen or phosphorus.

Furthermore, the shape and the arrangement of the connection member 64 and the wiring 66 are not limited to the exemplified ones. For example, the connection member 64 may be a "contact point connector" which is provided around the light source 62 in a frame shape and is connected via a contact point.

In addition, elements preferably formed of resin, which does not substantially contain halogen or phosphorus, are not limited to the reflection portion main body 14, the connection member 64, and the wiring 66. That is, if the elements are the main body portion 52, the installation substrate 60, the cover 56, and in addition, various elements provided in the lighting apparatus, and are the elements to which light emitted from the light source 62 is directly or indirectly irradiated, the elements are preferably formed of resin which does not substantially contain halogen or phosphorus.

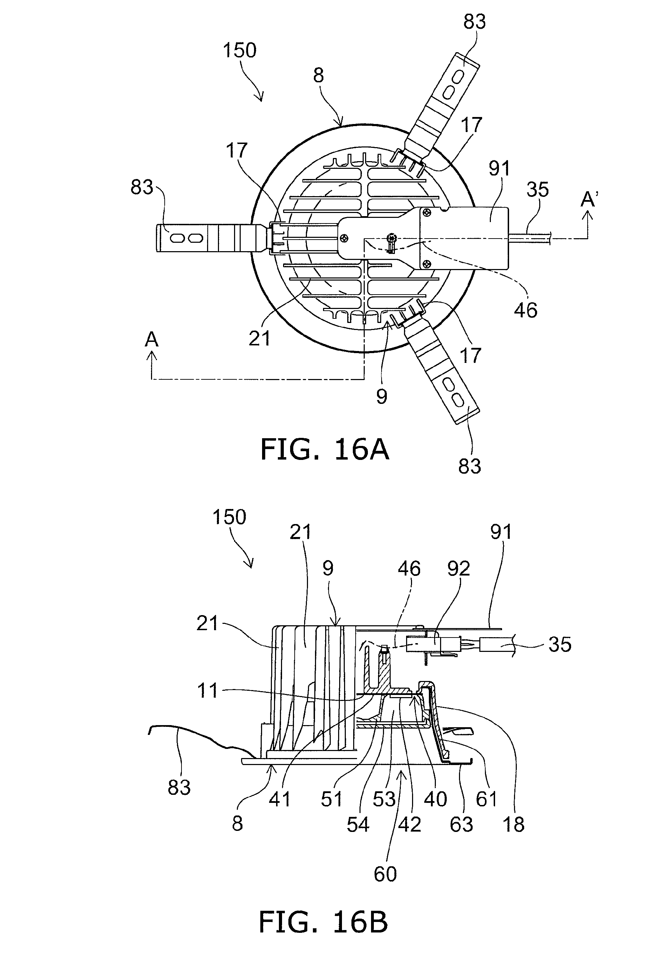

FIGS. 16A and 16B are also a schematic view illustrating a lighting apparatus according to another embodiment.

In addition, FIG. 16A is a top view of the lighting apparatus, and FIG. 16B is a partial cross-sectional view of an A-A' direction in FIG. 16A.

A lighting apparatus 150 according to the exemplary embodiment mainly has a radiator 9, a light source 40 and a frame 8.

The radiator 9 is provided with a plurality of radiation fins 21. Furthermore, the radiator 9 has a cylindrical side wall portion 18. An outer wall of the side wall portion 18 is also provided with a plurality of radiation fins 21.

The light source 40 has a substrate 41, and a light emitting element 42 which is implemented on the substrate 41 and is covered by a wavelength conversion layer. A back surface of an opposite side of the implementation surface with the light emitting element 42 implemented thereon in the substrate 41 comes into contact with the substrate support surface 11 of the radiator 9.

The lighting emitting element 42 is implemented so that an irradiation surface of light faces the opposite side of the implementation surface of the substrate 41. Furthermore, a connector (not illustrated) is also implemented on the implementation surface of the substrate 41. A wiring 46 is connected to the connector.

The wiring 46 is connected to a terminal block 92 illustrated in FIG. 16B. The terminal block 92 is attached to an attachment plate 91 which is screwed and fixed to the upper end of the radiation fin 21. The terminal block 92 is connected to an external power source (not illustrated) through the wiring 35 which is led to the outside of the lighting apparatus 150.

The frame 60 functions as a clock decorative rim that covers an inner surface and a lower end portion of the side wall portion 18 of the radiator 9. Furthermore, the frame 60 also has a function of controlling a light distribution or shading of light that is emitted from the light source 40.

The frame 60 has a cylinder portion 61 which is superimposed on the inside of the side wall portion 18 of the radiator 9. The cylinder portion 61 surrounds a space of a lower portion of the light source 40. A lower end portion 63 bent outward the cylinder portion 61 is provided in the lower end of the cylinder portion 61. The lower end portion 63 is formed in a ring shape and covers the lower end of the side wall portion 18 of the radiator 9.

As illustrated in FIG. 16B, a reflection plate 51 is provided in the inner space of the cylinder portion 61. In the reflection plate 51, a plurality of the optical guide hole 53 is provided as a through hole.

The reflection plate 51 is provided on the substrate 41. Furthermore, when the reflection plate 51 is provided on the substrate 41, the light emitting element 42 is located inside an optical guide hole 53. An inner wall surface of the optical guide hole 53 functions as a reflection surface.

Furthermore, a light transmission cover 54 is provided in the inner space of the cylinder portion 61 so as to cover the reflection plate 51.

In the outer wall of the side wall portion 18 of the radiator 9, as illustrated in FIG. 16A, a plurality (for example, three) of an installation spring attachment portions 17 is provided. One end portions of installation springs 83 serving as plate springs are inserted and fixed to the respective installation spring attachment portions 17.

Moreover, the lighting apparatus 150 is attached to an implantation hole provided on the ceiling using elasticity of the installation spring 83. That is, the lighting apparatus 150 according to the exemplary embodiment is a down light type lighting apparatus.

Even in the lighting apparatus 150 according to the exemplary embodiment, elements, which are various elements provided in the lighting apparatus 150 to which light emitted from the light source 40 is directly or indirectly irradiated, are preferably formed of resin that does not substantially contain halogen or phosphorus.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions. Moreover, above-mentioned embodiments can be combined mutually and can be carried out.

## Claims

1. A lighting apparatus (10, 10a, 10b, 50 and 150) comprising:
light sources (20, 40 and 62) including a light emitting element (30);
a reflection portion main body (14) that is formed of an incombustible resin and is provided at an irradiation side of the light sources (20, 40 and 62); and
a reflection layer (82) that is formed of resin substantially not containing halogen or phosphorus and is provided on a surface of the reflection portion main body (14).

2. The apparatus (10, 10a, 10b, 50 and 150) according to claim 1, wherein a thickness dimension of a portion of the reflection layer (82) near the light sources (20, 40 and 62) is thicker than a thickness dimension of a portion far from the light source (20, 40 and 62).

3. The apparatus (10, 10a, 10b, 50 and 150) according to claim 1 or 2, wherein the thickness dimension of the reflection layer (82) is uniform.

4. The apparatus (10, 10a, 10b, 50 and 150) according to claim 1 or 2, wherein the thickness dimension of the reflection layer (82) becomes gradually thicker as the reflection layer gets closer to the light source (20, 40 and 62).

5. The apparatus (10, 10a, 10b, 50 and 150) according to claim 1 or 2, wherein the thickness dimension of the reflection layer (82) becomes progressively thicker as the reflection layer gets closer to the light source (20, 40 and 62).

6. The apparatus (10, 10a, 10b, 50 and 150) according to any one of claims 1 to 5, wherein the thickness dimension of the reflection layer (82) is equal to or greater than 10 micrometers and is equal to or less than 2 millimeters.

7. The apparatus (10, 10a, 10b, 50 and 150) according to any one of claims 1 to 6, wherein the reflection layer (82) is provided in at least a portion on which light emitted from the light source (20, 40 and 62) hits.

8. The apparatus (10, 10a, 10b, 50 and 150) according to any one of claims 1 to 7, wherein the reflection layer (82) is white.

9. The apparatus (10, 10a, 10b, 50 and 150) according to any one of claims 1 to 8, wherein resin substantially not containing halogen and phosphorous contains at least one of halogen and phosphorus of 1000 ppm or more and 2500 ppm or less with respect to a gross weight of resin.

10. The apparatus (10, 10a, 10b, 50 and 150) according to any one of claims 1 to 9, wherein the incombustible resin has a grade in a UL 94 standard that is equal to or greater than a V-1 grade.

11. The apparatus (10, 10a, 10b, 50 and 150) according to any one of claims 1 to 10, wherein light emitted from the light source (20, 40 and 62) includes a peak of a strength in which a wavelength is equal to or less than 500 nanometers.

12. The apparatus (10, 10a, 10b, 50 and 150) according to any one of claims 1 to 11, wherein the light source (20, 40 and 62) includes an element containing silver.
